(19) **Europäisches Patentamt**

**European Patent Office**

**Office européen des brevets**

(11) Veröffentlichungsnummer: **0 116 972**
**B1**

(12) # EUROPÄISCHE PATENTSCHRIFT

(45) Veröffentlichungstag der Patentschrift:
**31.05.89**

(51) Int. Cl.⁴: **H 03 M 7/00**

(21) Anmeldenummer: **84101682.7**

(22) Anmeldetag: **17.02.84**

(54) **Umschaltbarer Umcodierer.**

(30) Priorität: **22.02.83 DE 3306113**

(43) Veröffentlichungstag der Anmeldung:
**29.08.84 Patentblatt 84/35**

(45) Bekanntmachung des Hinweises auf die Patenterteilung:
**31.05.89 Patentblatt 89/22**

(84) Benannte Vertragsstaaten:
**AT BE CH DE FR GB IT LI NL**

(56) Entgegenhaltungen:
**US-A-3 434 059**

**INTERNATIONAL JOURNAL OF ELECTRONICS, Band 46, Nr. 6, Juni 1979, Seiten 611-620, Taylor & Francis Ltd, London, GB; K.W. CURRENT: "Quaternary logic techniques for simplified integrated digital signal processing circuitry"
ELECTRO-OPTICAL SYSTEMS DESIGN, Band 13, Nr. 12, Dezember 1981, Seiten 33-35, Chicago, US; P. O'NEIL: "Using pulse-bipolar encoding in fiber-optic links"
TELCOM REPORT, Band 3, Nr. 5, Oktober 1980, Seiten 387-389, Passau, DE; J. DÖMER et al.: "FM-Richtfunksysteme übertragen Digitalsignale mit 8448 Kbit/s"**

(73) Patentinhaber: **Siemens Aktiengesellschaft Berlin und München, Wittelsbacherplatz 2, D-8000 München 2 (DE)**

(72) Erfinder: **Meyer, Fritz, Dr.- Ing., Wifostrasse 5, D-8034 Germering (DE)**

**Beschreibung**

Die Erfindung betrifft einen umschaltbaren Umcodierer für AMI-codierte Signale in Signale im Binärcode oder im Differenz-Binärcode.

Bei der Übertragung digitaler Signale über Kupferleitungen wird häufig der AMI-Code verwendet, bei dem es sich um einen redundanten bipolaren Code handelt. Die Regenerierung AMI-codierter Signale auf der Strecke kann so erfolgen, daß die AMI-codierten Signale in einen positiven und in einen negativen Impulszug aufgeteilt werden und beide Impulszüge für sich als unipolare Signale regeneriert werden. Eine entsprechende Schaltungsanordnung ist beispeilsweise aus US-A-3 434 059 bekannt. Ein weniger aufwendiges Verfahren der Regenerierung AMI-codierter Signale besteht darin, diese in den sogenannten Differenz-Binärcode umzucodieren, so daß dann nur ein binäres Signal zu regenerieren ist. Die Umcodierung kann beispielsweise dadurch geschehen, daß die empfangenen AMI-codierten Signale nach der Entzerrung einem Schmitt-Trigger zugeführt werden, wobei die Schaltschwellen des Schmitt-Triggers mit den Schwellenspannungen des AMI-codierten Signals übereinstimmen.

Mit dem Ausbau der Lichtwellenleiterübertragungsstrecken zu höheren Übertragungsgeschwindigkeiten und großen Übertragungsstrecken wird sich immer hausiger eine Schnittstelle ergeben, an der ein Übergang des digitalen Signals von der Kupferleitung auf den Lichtwellenleiter erfolgt. Ternäre oder pseudoternäre Signale können bei Verzicht auf Wellenlängenmultiplex über Lichtwellenleiter in einfacher Weise nur dadurch übertragen werden, daß zum Lichtpegel 1 noch der Lichtpegel 1/2 eingeführt wird, wodurch sich aber praktisch eine Halbierung der möglichen Streckenlänge ergibt. Aus diesem Grunde erfolgt die Übertragung digitaler Signale über Lichtwellenleiter in der Regel dadurch, daß die digitalen Signale im binären Code übertragen werden. Damit ergibt sich an der Schnittstelle die Notwendigkeit, die AMI-codierten Signale in einfacher Weise in binär-codierte Signale umzuformen.

Im Hinblick auf eine universelle Anwendbarkeit ist also an den digitalen Schnittstellen ein Umcodierer erwünscht, der AMI-codierte Signale wahlweise in den Differenz-Binärcode oder in den Binärcode umwandelt.

Die Aufgabe der Erfindung besteht also darin, einen einfachen und leicht integrierbaren Umcodierer anzugeben, der zwischen der Umcodierung vom AMI-Code in den Binärcode und vom AMI-Code in den Differenz-Binärcode umschaltbar ist.

Erfindungsgemäß wird die Aufgabe dadurch gelöst, daß eine Differenzverstärkeranordnung vorgesehen ist, die zwei emittergekoppelte Differenzverstärker mit jeweils einer Eingangsstufe und einer Referenzstufe enthält, daß die Stufeneingänge der beiden Eingangsstufen miteinander und mit einen Signaleingang verbunden sind, daß die Stufeneingänge der Referenzstufen jeweils getrennt mit einer Referenzspannungsquelle verbunden sind und dabei die Spannung der ersten Referenzspannungsquelle der Schwellenspannung der negativen Eingangsimpulse und die Spannung der zweiten Referenzspannungsquelle der Schwellenspannung der positiven Eingangsimpulse entspricht, daß der Ausgangsanschluß der Eingangsstufe des emittergekoppelten Differenzverstärkers mit dem Ausgangsanschluß der Referenzstufe des zweiten und der Ausgangsanschluß der Referenzstufe des ersten emittergekoppelten Differenzverstärkers mit den Ausgangsanschluß der Eingangsstufe des zweiten emittergekoppelten Differenzverstärkers verbunden sind, daß mit einem der beiden Ausgangsanschlußpaare und damit mit dem Ausgangsanschluß der Differenzverstärkeranordnung über einen Schalter ein getaktetes D-Flipflop verbunden ist, dessen nichtinvertierender Ausgang mit dem Ausgangsanschluß des Umcodierers verbunden ist, daß der Schalter in der ersten Schalterstellung zur Erzeugung von im Differenz-Binärcode vorliegenden Signalen den invertierenden Ausgang des D-Flipflops mit dessen D-Eingang und außerdem den Ausgang der Differenzverstärkeranordnung mit dem Taktübernahmeeingang verbindet, daß in der zweiten Schalterstellung des Schalters zur Erzeugung binärer Ausgangssignale der Ausgang der Differenzverstärkeranordnung mit den D-Eingang des D-Flipflops und dessen Taktübernahmeeingang mit einem Anschluß für den logischen Einspegel verbunden ist.

Im Hinblick auf eine universelle Anwendbarkeit bietet der erfindungsgemäße Umcodierer den erheblichen Vorteil, unter Anwendung handelsüblicher Bauteile bis zu Schrittgeschwindigkeiten von etwa 750 Mbit/s einsetzbar zu sein.

Zweckmäßige Weiterbildungen des erfindungsgemäßen Umcodierers sind in den Patentansprüchen 2 bis 4 beschrieben.

Die Erfindung soll im folgenden anhand der Zeichnung näher erläutert werden.

In der Zeichnung zeigt

Fig. 1 ein Impulsdiagramm zu den verschiedenen auftretenden Codes,

Fig. 2 die prinzipielle Schaltung des Umcodierers nach der Erfindung und

Fig. 3 ein detailliertes Schaltbild des Umcodierers nach Fig. 2.

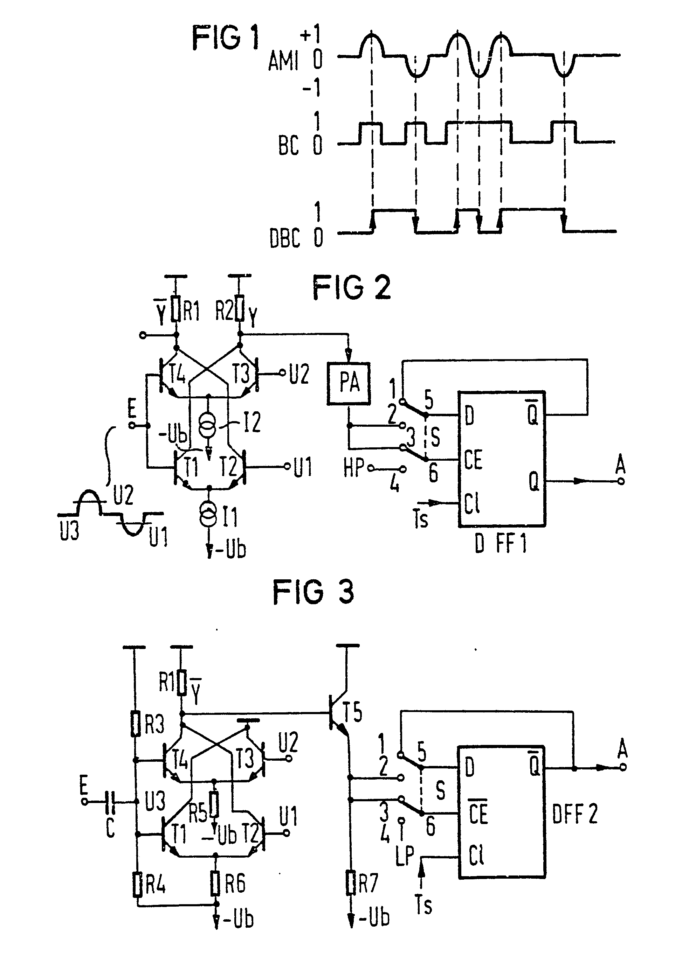

In der Fig. 1 ist ein digitales Signal dargestellt, das in der oberen Zeile in AMI-Code, in der mittleren Zeile im Binärcode und in der unteren Zeile im Differenz-Binär-Code vorliegt. Entsprechend dem Codegesetz des AMI-Codes folgen in der oberen Zeile immer Eins-Impulse abwechselnder Polarität aufeinander. Diese führen zu Eins-Impulsen im Binärcode entsprechend der mittleren Zeile und zu einem Wechsel des Logikpegels im Signal der unteren Zeile entsprechend dem Differenz-Binär-Code (DBC).

Der umschaltbare Umcodierer nach der Fig. 2 enthält im Signalfluß nacheinander eine Differenzverstärkeranordnung, eine Pegelanpaßstufe PA, einen Schalter S und ein D-Flipflop DFF. Die Differenzverstärkeranordnung enthält zwei emittergekoppelte Differenzverstärker, die den ersten und den zweiten Transistor T1, T2 bzw. den dritten und den vierten Transistor T3, T4 enthalten. Der erste und der vierte Transistor T1, T4 bilden dabei jeweils die Eingangsstufe und der zweite und der dritte Transistor T2, T3 bilden die Referenzstufe des jeweiligen Differenzverstärkers. Die Basisanschlüsse des ersten und des vierten Transistors T1, T4 sind miteinander und mit einem Eingangsanschluß E verbunden, neben dem das AMI-codierte Eingangssignal mit einem positiven und einem negativen Eingangsimpuls dargestellt ist. Der Emitteranschluß des ersten Transistors T1 ist über eine erste Stromquelle I1 mit Betriebsspannung -Ub sowie direkt mit dem Emitteranschluß des zweiten Transistors T2 verbunden.

Entsprechend ist der Emitteranschluß des vierten Transsistors T4 über eine zweite Stromquelle I2 mit dem Betriebsspannungsanschluß -Ub und außerdem direkt mit dem Emitteranschluß des dritten Transistors T3 verbunden. Der Basisanschluß des zweiten Transistors T2 ist mit einer Quelle U1 für eine erste Referenzspannung und der Basisanschluß des dritten Transistors T3 ist mit einer zweiten Quelle U2 für eine weitere Referenzspannung verbunden. Die Spannungen der ersten und der zweiten Referenzspannungsquelle liegen beim Schwellwert, also der halben Impulsamplitude der positiven bzw. negativen Eingangsimpulse, während die Basisanschlüsse des ersten und des vierten Transistors T1, T4 eine Spannung U3 entsprechend dem logischen Null-Pegel der Eingangssignale erhalten. Der Kollektoranschluß des ersten Transistors T1 ist mit dem Kollektoranschluß des dritten Transistors T3, über einen zweiten Widerstand R2 mit Bezugspotential und außerdem mit einem Ausgangsanschluß Y verbunden. Der Kollektoranschluß des zweiten Transistors T2 ist mit dem Kollektoranschluß des vierten Transistors T4, mit einem Ausgangsanschluß Y̅ für ein inverses Ausgangssignal und außerdem über einen ersten Widerstand R1 mit Bezugspotential verbunden. Mit einem der beiden Ausgangsanschlüsse Y, Y̅ ist der Eingang einer Stufe PA zur Pegelanpassung verbunden; das Belegen des jeweiligen Ausgangsanschlusses hängt davon ab, ob in der Stufe PA zur Pegelanpassung eine Phasendrehung des übertragenen Signals um 180 Grad erfolgt oder nicht, und ob beim nachgeschaltetem D-Flipflop ein invertierender oder ein nichtinvertierender Eingang zur Verfügung steht.

Mit dem Ausgang der Stufe PA zur Pegelanpassung sind der zweite und der dritte Signaleingang eines Schalter S verbunden, dessen erster Signaleingang mit dem invertierenden Ausgang Q̅ des D-Flipflops DFF verbunden ist. Der vierte Signaleingang des Schalters S ist mit einer Quelle HP für den logischen Einspegel verbunden, der erste Signalausgang 5 des Schalters S ist mit dem D-Eingang des D-Flipflops und der zweite Signalausgang 6 des Schalters S ist mit dem Taktübernahmeeingang CE (clock enable) des D-Flipflops verbunden. Der Takteingang CI des D-Flipflops ist an eine Quelle Ts für ein Taktsignal mit einer Folgefrequenz entsprechend der Bitrate der zu erzeugenden binären Signale verbunden, während an den nichtinvertierenden Ausgang Q des D-Flipflops der Ausgang 4 des Umcodierers angeschlossen ist.

Zur Erläuterung der Anordnung nach Fig. 2 wird zunächst davon ausgegangen, daß am Signaleingang E kein Eingangsimpuls anliegt, dort also der logische Nullzustand herrscht. In diesem Fall leiten der erste und der dritte Transistor T1, T3 sodaß deren Kollektorströme durch den zweiten Widerstand R2 fließen und am Ausgang Y ein stark negatives-Potential erzeugen, dem der logische Nullzustand zugeordnet wurde. Gleichzeitig sperren in diesem Falle der zweite und der vierte Transistor T2, T4, sodaß am invertierenden Ausgang Y̅ nahezu Nullpotential liegt.

Bei einem positiven Eingangsimpuls leiten der erste und der vierte Transistor T1, T4 während der zweite und der dritte Transistor T2, T3 gesperrt sind. Bei einem negativen Eingangsimpuls leiten der zweite und der dritte Transistor T2, T3, während der erste und der vierte Transistor T1, T4, gesperrt sind. Damit fließt sowohl bei positiven als auch bei negativen Eingangsimpulsen jeweils der Kollektorstrom eines Transistors durch den ersten bzw. zweiten Widerstand R1, R2. Dieser Kollektorstrom erzeugt am ersten Widerstand R1 und damit am invertierenden Ausgang Y̅ ein negativeres Potential als beim Nullzustand am Eingang E und am zweiten Widerstand R2, also am nichtinvertierenden Ausgang Y ein positiveres Potential, dem der logische Einszustand zugeordnet wurde. Das Eingangssignal der Stufe PA zur Pegelanpassung ist also sowohl bei positiven als auch bei negativen AMI-Eingangsimpulsen auf dem logischen Einszustand.

Der an den Ausgang der Stufe PA zur Pegelanpassung angeschlossene Schalter verbindet in der ersten Schalterstellung den ersten Signaleingang 1 mit dem ersten Signalausgang 5 und dem dritten Signaleingang 3 mit dem zweiten Signalausgang 6; in dieser Schalterstellung werden Ausgangssignale im Differenz-Binärcode erzeugt.

Zur Erzeugung binärer Ausgangssignale ist der Schalter S in der zweiten Schalterstellung und verbindet dann den zweiten Signaleingang 2 mit dem ersten Signalausgang 5 und den vierten Signaleingang 4 mit dem zweiten Signalausgang 6. Durch die Rückkopplung vom invertierenden Ausgang Q̄ auf den Dateneingang D des D-Flipflops wird dieses in der ersten Schalterstellung als Binärteiler betrieben. Über den Taktübernahmeeingang CE wird das Umschalten des·Flipflops zusätzlich durch das Ausgangssignal der Differenzverstärkeranordnung gesteuert. Liegt der Taktübernahmeeingang CE auf dem logischen Nullpegel, dann ist der Takteingang des D-Flipflops blockiert. Nur im Falle daß am nichtinvertierenden Ausgang Y der Differenzverstärkeranordnung der logische Einspegel ansteht, schaltet also unter der Voraussetzung, daß die Stufe PA zur Pegelanpassung keine Phasendrehung vornimmt, das D-Flipflop in den entgegengesetzten Ausgangszustand. Bei dem logischen Einspegel am nichtinvertierenden Ausgang Y erfolgt also immer ein Wechsel im Ausgangssignal des D-Flipflops. Damit liegt dieses binäre Ausgangssignal im Differenz-Binärcode vor. In der zweiten Schalterstellung ist der D-Eingang des D-Flipflops über die Pegelanpaßstufe mit dem Ausgang Y der Differenzverstärkeranordnung verbunden, während am Taktübernahmeeingang CE der logische Einspegel anliegt und dieser Taktübernahmeeingang damit wirkungslos ist. Damit wird der mögliche Zustand am nichtinvertierenden Ausgang Y der Differenzverstärkeranordnung nach jedem Taktimpuls direkt auf den nichtinvertierenden Ausgang Q des D-Flipflops übertragen, sodaß damit der normale Betrieb des D-Flipflops vorliegt und dieses ein Ausgangssignal im Binärcode erzeugt.

In der Fig. 3 ist ein praktisches Ausführungsbeispiel des Umcodierers nach Fig. 2 dargestellt. Im Hinblick auf die Erzeugung einer Basisvorspannung an den Basisanschlüssen des ersten und des vierten Transitors T1, T4 wurde ein aus den Widerständen R3 und R4 bestehender Basisspannungteiler vorgesehen, der auf der einen Seite mit Bezugspotential und auf der anderen Seite mit Betriebsspannung -Ub verbunden ist, außerdem wurde ein Koppelkondensator C vorgesehen, der der gleichstrommäßigen Trennung des Eingangs E von den Basisanschlüssen dient. Die erzeugte Basisvorspannung entspricht dabei dem Nullpegel der AMI-codierten Eingangssignale. Im Ausführungsbeispiel wurde ein Master-Slave D-Flipflop verwendet, das einen inversen Taktübernahmeeingang C̄Ē enthält. Aus diesem Grunde wurde der Basisanschluß des als Emitterfolgestufe geschalteten fünften Transistors T5 mit dem inversen Ausgangsanschluß Ȳ der

Differenzverstärkeranordnung verbunden. Der Ausgang des Emitterfolgers ist mit dem zweiten und dem dritten Signaleingang 2, 3 des Schalters S verbunden, während der erste Signaleingang 1 dieses Schalters mit dem invertierenden Ausgang Q̄ des D-Flipflops verbunden ist und der vierte Signaleingang 4 auf Nullpegel liegt, sodaß er im vorliegenden Falle nicht weiter beschaltet wurde. Der Ausgangsanschluß A des Umcodierers ist mit dem invertierenden Ausgang Q̄ des D-Flipflops verbunden. In der ersten Schalterstellung zur Erzeugung von Ausgangssignalen im Differenz-Binärcode schaltet das Master-Slave D-Flipflop DFF2 also um, wenn am inversen Taktübernahmeeingang C̄Ē der Nullpegel liegt, während bei Anliegen des Einspegels der Takteingang blociert ist. Durch die Verwendung des invertierenden Ausganges Q̄ wurde die Invertierung des Signals am D-Eingang des D-Flipflops durch dessen Anschluß an den invertierenden Ausgang Ȳ der Differenzverstärkeranordnung kompensiert.

Anstelle des mechanischen Umschalters S können in bekannter Weise auch Logikgatter in den Signalweg zur Signalumschaltung eingeführt werden, die ihrerseits durch mechanische Umschalter gesteuert werden. Dadurch lassen sich Signalverzerrungen bei hohen Schrittgeschwindigkeiten verringern.

**Patentansprüche**

1. Umschaltbarer Umcodierer für AMI-codierte Signale in Signale im Binärcode oder im Differenz-Binär-Code,
   dadurch gekennzeichnet,
   daß eine Differenzverstärkeranordnung vorgesehen ist, die zwei emittergekoppelte Differenzverstärker mit jeweils einer Eingangsstufe (T1, T4) und einer Referenzstufe (T2, T3) enthält, daß die Stufeneingänge der beiden Eingangsstufen (T1, T4) miteinander und mit einem Signaleingang (E) verbunden sind, daß die Stufeneingänge der Referenzstufen (T2, T3) jeweils getrennt mit einer Referenzspannungsquelle (U1, U2) verbunden sind und dabei die Spannung der ersten Referenzspannungsquelle (U1) der Schwellenspannung der negativen Eingangsimpulse und die Spannung der zweiten Referenzspannungsquelle (U2) der Schwellenspannung der positiven Eingangsimpulse entspricht, daß der Ausgangsanschluß der Eingangsstufe (T1) des ersten emittergekoppelten Differenzverstärkers mit dem Ausgangsanschluß der Referenzstufe (T3) des zweiten und der Ausgangsanschluß der Referenzstufe (T2) des ersten emittergekoppelten Differenzverstärkers mit dem Ausgangsanschluß Eingangsstufe (T4) des zweiten emittergekoppelten Differenzverstärkers verbunden sind, daß mit einem der beiden Ausgangsanschlußpaare und damit mit dem Ausgangsanschluß der Differenzverstärkeranordnung über einen Schalter (S) ein getaktetes D-Flipflop (DFF) verbunden ist, dessen nichtinvertierender Ausgang (Q) mit dem Ausgangsanschluß (A) des Umcodierers verbunden ist, daß der Schalter (S) in der ersten Schalterstellung zur Erzeugung von im Differenz-Binärcode vorliegenden Signalen den invertierenden Ausgang (Q̄) des D-Flipflops mit dessen D-Eingang und außerdem den Ausgang der Differenzverstärkeranordnung mit dem Taktübernahmeeingang (CE) verbindet, daß in der zweiten Schalterstellung des Schalters (S) zur Erzeugung binärer Ausgangssignale der Ausgang der Differenzverstärkeranordnung mit dem D-Eingang des D-Flipflops und dessen Taktübernahmeeingang (CE) mit einem Anschluß für den logischen Einspegel verbunden ist.

2. Umcodierer nach Patentanspruch 1, dadurch gekennzeichnet, daß mit dem invertierenden Ausgang des D-Flipflops (DFF2) der Ausgang (A) des Umcodierers verbunden ist, daß mit dem zweiten Signalausgang (6) des Schalters (S) der inverse Taktübernahmeeingang (CE̅) des D-Flipflops (DFF2) und mit dem vierten Signaleingang (4) des Schalters (S) der logische Nullpegel verbunden ist.

3. Umcodierer nach Patentansprüchen 1 oder 2, dadurch gekennzeichnet, · daß zwischen dem Ausgang der Differenzverstärkeranordnung und dem Eingang des Schalters (S) eine Emitterfolgerstufe (T5) eingeschaltet ist.

4. Umcodierer nach Patentansprüchen 1 oder 2, dadurch gekennzeichnet, daß die Eingangsanschlüsse der Eingangsstufen der Differenzverstärkeranordnung mit einer Basisvorspannungsquelle (U3) verbunden sind und deren Vorspannung zwischen den Spannungen der beiden Referenzspannungsquellen (U1, U2) liegt.

5. Umcodierer nach Patentansprüchen 1 oder 2, dadurch gekennzeichnet, daß der Schalter (S) zwei Logikschaltungen enthält, die jeweils über einen Eingang mit dem Ausgang eines mechanischen Schalters verbunden sind.

## Claims

1. Switchable transcoder for AMI-coded signals into signals in binary code or in differential binary code, characterized in that a differential amplifier arrangement is provided, which includes two emitter-coupled differential amplifiers with one input stage (T1, T4) and one reference stage (T2, T3) in each case, in that the stage inputs of the two input stages (T1, T4) are connected to each other and to a signal input (E), in that the stage inputs of the reference stages (T2, T3) are connected separately in each case to a reference voltage source (U1, U2) and thereby the voltage of the first reference voltage source (U1) corresponds to the threshold voltage of the negative input pulses and the voltage of the second reference voltage source (U2) corresponds to the threshold voltage of the positive input pulses, in that the output terminal of the input stage (T1) of the first emitter-coupled differential amplifier is connected to the output terminal of the reference stage (T3) of the second and the output terminal of the reference stage (T2) of the first emitter-coupled differential amplifier is connected to the output terminal of the input stage (T4) of the second emitter-coupled differential amplifier, in that a clocked delay flip-flop (DFF), the non-inverting output (Q) of which is connected to the output terminal (A) of the transcoder, is connected to one of the two output terminal pairs, and thus to the output terminal of the differential amplifier arrangement, via a switch (S), in that the switch (S), in the first switch position for the generation of signals in differential binary code, connects the inverting output (Q̄) of the delay flip-flop to its delay input and also connects the output of the differential amplifier arrangement to the clock acceptance input (CE), in that, in the second switch position of the switch (S) for the generation of binary output signals, the output of the differential amplifier arrangement is connected to the delay input of the delay flip-flop and its clock acceptance input (CE) is connected to a terminal for the logical one level.

2. Transcoder according to Patent Claim 1, characterized in that the output (A) of the transcoder is connected to the inverting output of the delay flip-flop (DFF2), in that the inverse clock acceptance input (CE̅) of the delay flip-flop (DFF2) is connected to the second signal output (6) of the switch (S) and the logical zero level is connected to the fourth signal input (4) of the switch (S).

3. Transcoder according to Patent Claims 1 or 2, characterized in that an emitter follower stage (T5) is connected between the output of the differential amplifier arrangement and the input of the switch (S).

4. Transcoder according to Patent Claims 1 or 2, characterized in that the input terminals of the input stages of the differential amplifier arrangement are connected to a base bias source (U3) and the bias of which lies between the voltages of the two reference voltage sources (U1, U2).

5. Transcoder according to Patent Claims 1 or 2, characterized in that the switch (S) contains two logic circuits, which are connected in each case via an input to the output of a mechanical switch.

## Revendications

1. Transcodeur commutable pour des signaux codés selon le code AMI en des signaux codés selon le code binaire ou selon le code binaire différentiel, caractérisé par le fait qu'il est prévu un dispositif d'amplification différentielle, qui contient deux amplificateurs différentiels à émetteurs couplés, comportant chacun un étage d'entrée (T1, T4) et un étage de référence (T2, T3), que les entrées des deux étages d'entrée (T1, T4) sont reliées entre elles et à une entrée (E) des signaux, que les entrées des étages de référence (T2, T3) sont reliées séparément à des sources respectives de tension de référence (U1, U2) et que la tension de la première source de tension de référence (U1) correspond à la tension de seuil des impulsions d'entrée négatives et la tension de la seconde source de tension de référence (U2) correspond à la tension de seuil des impulsions d'entrée positives, que la borne de sortie de l'étage d'entrée (T1) du premier amplificateur différentiel à émetteurs couplés est raccordée à la borne de sortie de l'étage de référence (T3) du second amplificateur différentiel à émetteurs couplés et que la borne de sortie de l'étage de référence (T2) du premier amplificateur différentiel à émetteurs couplés est raccordée à la borne de sortie de l'étage d'entrée (T4) du second amplificateur différentiel à émetteurs couplés, qu'à l'un des deux couples de bornes de sortie et par conséquent à la borne de sortie du dispositif d'amplification différentielle est raccordée, par l'intermédiaire d'un commutateur (S), une bascule bistable de type D cadencée (DFF), dont la sortie non inverseuse (Q) est reliée à la borne de sortie (A) du transcodeur, que, dans sa première position de commutation servant à produire des signaux présents sous la forme du code binaire différentiel, le commutateur (S) relie la sortie inverseuse (Q̄) de la bascule bistable de type D à l'entrée D de cette dernière et en outre la sortie du dispositif d'amplification différentielle à l'entrée (CE) de transfert de la cadence, et que, lorsque le commutateur (S) est dans sa seconde position de commutation permettant de produire des signaux de sortie binaires, la sortie du dispositif d'amplification différentielle est reliée à l'entrée D de la bascule bistable de type D, et l'entrée (CE) de réception de la cadence de cette bascule bistable est reliée à une borne servant à établir le niveau logique un.

2. Transcodeur suivant la revendication 1, caractérisé par le fait que la sortie (A) du transcodeur est reliée à la sortie inverseuse de la bascule bistable de type D (DFF2), que l'entrée inverse (C̄Ē) de réception de la cadence de la bascule bistable de type D (DFF2) est reliée à la seconde sortie (6) des signaux du commutateur (S) et que le niveau logique zéro est relié à la quatrième entrée (4) de signaux du commutateur (S).

3. Transcodeur suivant les revendications 1 ou 2, caractérisé par le fait qu'un étage formant émetteur-suiveur (T5) est branché entre la sortie du dispositif d'amplification différentielle et l'entrée du commutateur (S).

4. Transcodeur suivant les revendications 1 ou 2, caractérisé par le fait que les bornes d'entrée des étages d'entrée du dispositif d'amplification différentielle sont reliées à la source de tension de polarisation de base (3), dont la tension de polarisation se situe entre les tensions des deux sources de tension de référence (U1, U2).

5. Transcodeur suivant les revendications 1 ou 2, caractérisé par le fait que le commutateur (S) comporte deux circuits logiques, qui sont reliés chacun par l'intermédiaire d'une entrée à la sortie d'un commutateur mécanique.

FIG 1

FIG 2

FIG 3